# EUROPEAN PATENT APPLICATION

(11) **EP 4 056 729 A1**
(43) Date of publication of application: **14.09.2022**
(21) Application number: 22159732.1
(22) Date of filing: 02.03.2022
(51) Int. Cl.: C23C 16/40, C23C 16/455, C23C 16/448, C23C 16/452, H01L 21/02

(54) **METHOD FOR PRODUCING BARIUM TITANATE FILM**

(30) Priority: 08.03.2021 JP 2021036247
(71) Applicant: Creative Coatings Co., Ltd., Shinjuku Tokyo 162-0842 (JP)
(72) Inventor: SATO, Eiji, Tokyo, 162-0842 (JP); SAKAMOTO, Hitoshi, Tokyo, 162-0842 (JP)
(74) Representative: Wunderlich & Heim Patentanwälte Partnerschaftsgesellschaft mbB

(57) **Abstract**

A method for forming a barium titanate film by conducting an ALD cycle, wherein the ALD cycle comprises forming a titanium oxide film and forming barium oxide film. In the forming of a titanium oxide film, TDMAT (Ti[N(CH₃)₂]₄) is used as first raw material gas, and an OH radical is used as reaction gas, and in the forming of barium oxide film, a vaporized barium complex is used as second raw material gas, and an OH radical is used as reaction gas, and the titanium oxide film and the barium oxide film are alternately formed in a normal order or a reverse order.

## Description

### BACKGROUND

The present invention relates to a method for producing a barium titanate film and the like.

Barium titanate films used as dielectric films in thin film capacitors, semiconductor integrated circuit devices, and the like have been formed by sintering. (JP2018-150205A and JP 2008-053281A)

Formation of a barium titanate film by sintering includes coating an object to be coated with a coating liquid and firing the coating film formed in the coating. Coating an object to be coated with a coating liquid includes preparing a coating liquid, filtering the coating liquid with a filter to remove impurities, cleaning the surface of the object to be coated, coating, drying after the coating, and the like. Firing the coated film includes preliminary firing and firing.

### SUMMARY

An object of the present invention is to provide a method for producing a barium titanate film, wherein the barium titanate film is formed from raw material gas and reaction gas.
(1) According to one aspect of the invention, there is provided a method for producing a barium titanate film, comprising forming a barium titanate film on a surface of an object by conducting an ALD cycle in a reaction vessel, wherein
   the ALD cycle comprises forming a titanium oxide film and forming barium oxide film,
   the forming of a titanium oxide film comprises:
   filling the reaction vessel with TDMAT (Tetrakis (dimethylamino) titanium:Ti[N(CH₃)₂]₄),
   exhausting the TDMAT from the reaction vessel,
   filling the reaction vessel with an OH radical, and
   exhausting the OH radical from the reaction vessel;
   the forming of barium oxide film comprises:
      filling the reaction vessel with a vaporized barium complex,
      exhausting the barium complex from the reaction vessel,
      filling the reaction vessel with an OH radical, and
      exhausting the OH radical from the reaction vessel; and
      the titanium oxide film and the barium oxide film are alternately formed in a normal order or a reverse order.

According to one aspect of the invention, a barium titanate film is formed by alternately forming a titanium oxide film and a barium oxide film in a normal order or a reverse order. This is because the barium titanate film can be formed when the titanium oxide film and the barium oxide film are regularly arranged. For this purpose, the titanium oxide film and the barium oxide film are alternately formed by ALD.

As two precursors for forming the titanium oxide film, TDMAT (Ti[N(CH₃)₂]₄) and a hydroxyl group OH radical (OH^{∗}) are used. For example, TDMAT (Ti[N(CH₃)₂]₄) as raw material gas is attached on an object surface even when secondly exhausted after firstly filling the reaction vessel. An OH radical (OH^{∗}) to thirdly fill the reaction vessel reacts with the TDMAT attached on the object surface, and a titanium oxide TiO₂ film is formed at an atomic layer level on the object surface. Fourthly, the OH radical (OH^{∗}) is exhausted from the reaction vessel.

As two precursors for forming the barium oxide film, a vaporized barium complex and a hydroxyl group OH radical (OH^{∗}) are used. A barium complex is a compound comprising a Ba ion located at the center of the molecule and ligands each having an unshared electron pair so as to surround the Ba ion. For example, the vaporized barium complex as the raw material gas is attached on the object surface even when sixthly exhausted after fifthly filling reaction vessel. An OH radical (OH^{∗}) to seventhly fill the reaction vessel reacts with the barium complex attached on the object surface, and a barium oxide BaO film is formed at an atomic layer level on the object surface. Eighthly, the OH radical (OH^{∗}) is exhausted from the reaction vessel.

These first to eighth processes are included in an ALD cycle, and the ALD cycle is repeated to alternately form the titanium oxide film and the barium oxide film. When the titanium oxide TiO₂ film and the barium oxide BaO film are regularly arranged, a barium titanate film BaTiO₃ is formed. The titanium oxide film and the barium oxide film may be formed alternately in a normal order or a reverse order. At the first film formation on the object, the first to fourth processes may be conducted after the fifth to eighth processes.

The film thickness of the barium titanate film is in proportion to the number of cycles of the ALD cycle to be repeated, and reduction in the number of cycles can results in a thinner film thickness. A barium titanate film to be formed as a thin film in this manner can be suitably used as a dielectric film that can have a lower dielectric constant depending on the film thickness.

(2) According to one aspect (1) of the invention, the barium complex may be sublimated and vaporized by heating under reduced pressure. The barium complex is solid at room temperature and is sublimated and vaporized when heated. The sublimation temperature can be lower under reduced pressure than at normal pressure. Without limitation to this, the barium complex may be dissolved in an organic solvent, and the solution may be supplied while atomized by ultrasonication or an injector.

(3) According to one aspect (2) of the invention, a vessel that contains the barium complex to be charged as solid and piping that connects the vessel with the reaction vessel are each heated and depressurized, and the vaporized barium complex can be introduced into the reaction vessel. The solid barium complex in the vessel, when heated under reduced pressure, can be vaporized by sublimation at a temperature lower than that under normal pressure and introduced as gas into the reaction vessel through the piping heated under reduced pressure.

(4) According to one aspect (3) of the invention, the reaction vessel can be evacuated to depressurize the vessel and the piping. In this manner, the equipment that evacuates the reaction vessel can be also used to bring the vessel and the piping under reduced pressure. After the vessel and the piping are brought under reduced pressure, for example, when the vessel and the piping are heated with a valve arranged on the piping closed and the reduced pressure maintained, the barium complex can be vaporized by sublimation. Thereafter, opening the valve enables the vaporized barium complex to be introduced into the reaction vessel.

(5) According to aspects (2) to (4) of the invention, the barium oxide film can be formed by heating the object. In the fifth to seventh processes, in which the barium complex is present in the reaction vessel, the reaction vessel is under reduced pressure. Accordingly, the barium complex present on the object in the fifth to seventh processes is heated under reduced pressure and thus can react with an OH radical (OH^{∗}).

(6) According to aspects (1) to (5) of the invention, the barium complex can be β-diketone. β-diketone here is a generic term for compounds having a -CO-C-CO- group. β-diketone may become a barium complex because of having a property of creating a chelate compound stable with various metal ions such as a Ba ion.

(7) According to one aspect (6) of the invention, there can be used a barium complex represented by the following chemical formula 1. The barium complex represented by the chemical formula 1 (β-diketone) is sublimated at about 250°C or more under normal pressure and can be sublimated at an about 200°C level under reduced pressure.

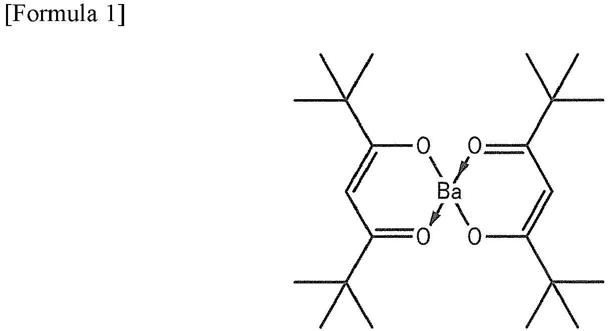

(8) According to one aspect (6) of the invention, there can be used a barium complex represented by the following chemical formula 2. The barium complex represented by the chemical formula 2 (β-diketone) is sublimated at about 300°C or more under normal pressure, and the sublimation temperature can be further lowered under reduced pressure.

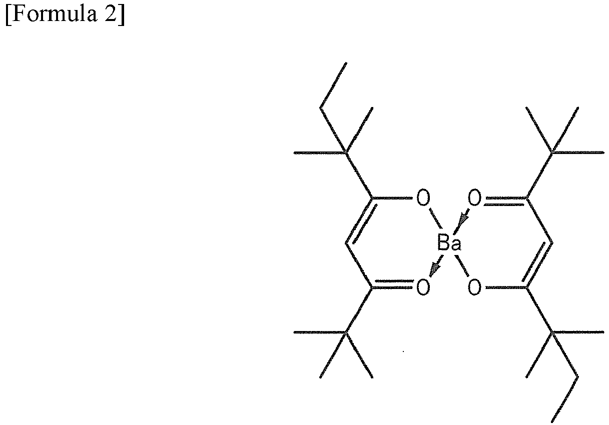

(9) According to one aspect (6) of the invention, there can be used a barium complex represented by the following chemical formula 3. The barium complex represented by the chemical formula 3 (β-diketone) is also sublimated at about 300°C or more under normal pressure, and the sublimation temperature can be further lowered under reduced pressure.

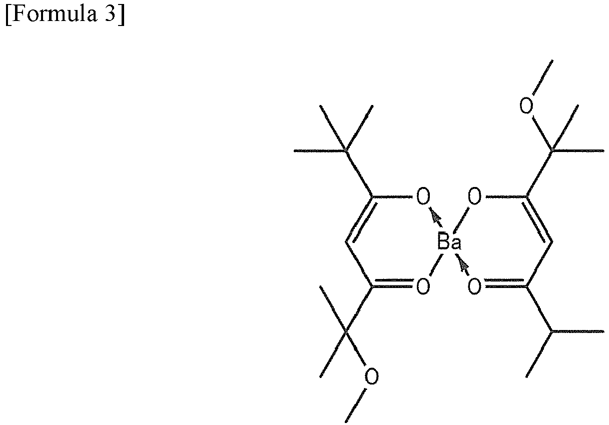

### BRIEF DESCRIPTION OF THE DRAWINGS

FIG. 1 illustrates an ALD apparatus with which one embodiment of the method of the invention is conducted.
FIG. 2 illustrates the details of the reaction gas source illustrated in FIG. 1.
FIG. 3 is a timing chart illustrating an embodiment of an ALD method conducted in the ALD apparatus illustrated in FIG. 1.
FIG. 4 is a graph illustrating characteristics of the volatilization ratio (sublimation ratio) of barium complexes A, B, and C.
FIG. 5 is a graph illustrating that the temperature characteristics of the volatilization ratio (sublimation ratio) of the barium complex A under normal pressure is different from the temperature characteristics thereof under reduced pressure.

### DESCRIPTION OF EXEMPLARY EMBODIMENTS

The following disclosure provides many different embodiments, or examples, for implementing different features of the provided subject matter. These are, of course, merely examples and are not intended to be limiting. In addition, the disclosure may repeat reference numerals and/or letters in the various examples. This repetition is for the purpose of simplicity and clarity and does not in itself dictate a relationship between the various embodiments and/or configurations discussed. Further, when a first element is described as being "connected" or "coupled" to a second element, such description includes embodiments in which the first and second elements are directly connected or coupled to each other, and also includes embodiments in which the first and second elements are indirectly connected or coupled to each other with one or more other intervening elements in between. Further, when the first element is described as "moving" relative to the second element, such description includes embodiments in which at least one of the first element and the second element moves relative to the other.

### 1. ALD Apparatus

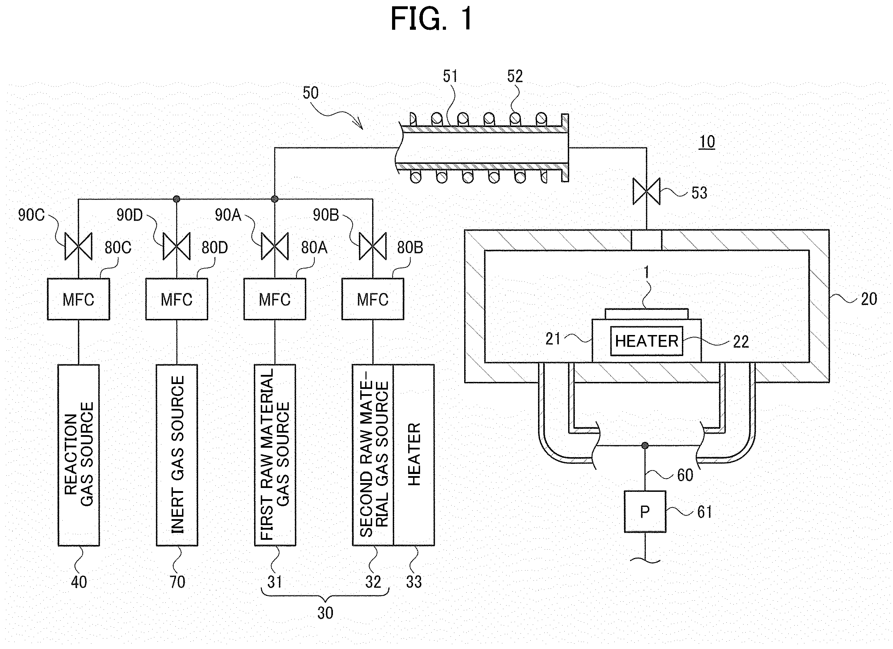

One example of an ALD apparatus 10 is illustrated in FIG. 1. The ALD apparatus 10 includes a reaction vessel 20, a raw material source 30, a reaction gas source 40, and a gas supplier 50. The reaction vessel 20 is a vessel in which a film is formed on an object to be processed (workpiece) 1. The reaction vessel 20 can have a mount 21 on which an object to be processed 1, for example, a substrate is to be placed. When the object to be processed is powder or the like, the powder may be maintained in a dispersed state inside the reaction vessel 20. The gas supplier 50 is connected to the reaction vessel 20 to introduce various gases into the reaction vessel 20. An exhaust pipe 60 is connected to the reaction vessel 20, and an exhaust pump 61 can exhaust inside the reaction vessel 20.

The gas supplier 50 connects the raw material source 30 and the reaction gas source 40 to the reaction vessel 20. The raw material source 30 includes a first raw material gas source 31 and a second raw material gas source 32. In the present embodiment, an inert gas source 70 is further disposed, enabling the reaction vessel 20 to be purged by supplying inert gas to the reaction vessel 20 via the gas supplier 50. Instead of introduction of purge gas, a vacuum pump 61 may exhaust inside the vessel 20. Gases from these gas sources 30 (31, 32), 40, and 70, after the supply timing and flow rate of the gases are controlled via flow controllers 80A to 80D and valves 90A to 90D, are alternatively supplied via the gas supplier 50 into the reaction vessel 20.

The first raw material gas source 31 supplies TDMAT (Ti[N(CH₃)₂]₄) as first raw material gas. The second raw material gas source 32 contains a barium complex solid at normal temperature as the source of the second raw material gas. A barium complex here is a compound comprising a Ba ion located at the center of the molecule and ligands each having an unshared electron pair so as to surround the Ba ion.

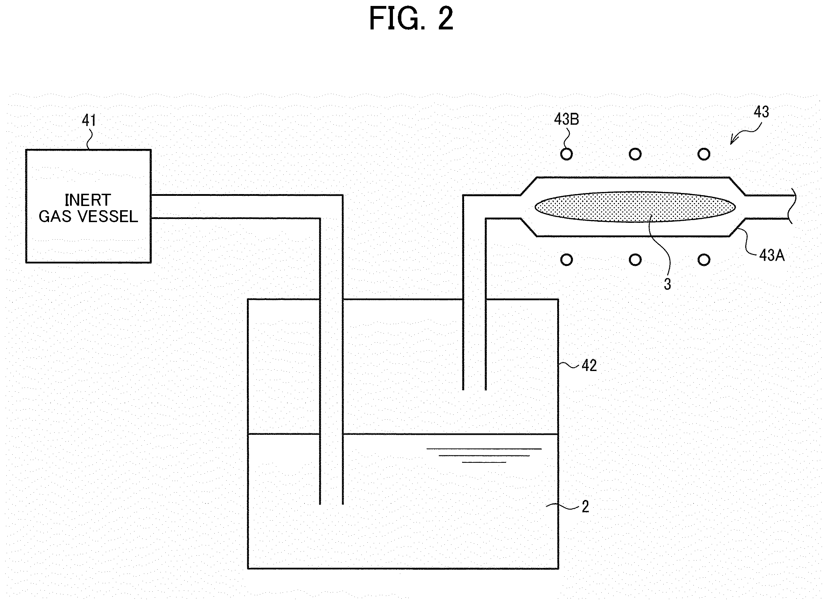

The reaction gas source 40 supplies an OH radical. The reaction gas source 40, as illustrated in FIG. 2, can include a vessel 41 for inert gas, for example, argon Ar, a humidifier 42 containing water 2, and an activator 43. The humidifier 42 sends out water bubbled with argon Ar as water vapor gas. In the activator 43, plasma 3 is generated by an induction coil 43B around a glass pipe 43A through which humidified argon gas passes to activate water vapor. This causes a reaction: Ar + H₂O → Ar^{∗} + OH^{∗} + H^{∗}, and thus an OH radical (OH^{∗}) can be created.

In the embodiment, the barium complex solid at normal temperature is vaporized by sublimation. For this purpose, a heater 33 is disposed at the second raw material gas source 32, as illustrated in FIG. 1. For the gas supplier 50, a heater 52 such as a heating wire is disposed around piping 51 shared among the gas sources 30 (31, 32), 40, and 70. Further, a valve 53 is arranged for turning on/off the connection between the piping 51 and the reaction vessel 20. Driving the exhaust pump 61 with the valves 53 and 90B opened and the other valves 90A, 90C, and 90D closed can exhaust the second raw material gas source 32 and the gas supplier 50 via the reaction vessel 20 and bring the second raw material gas source 32 and the gas supplier 50 under reduced pressure. Thereafter, the valve 53 is closed, and then the barium complex is heated by the heaters 33 and 52 under reduced pressure to the sublimation temperature or more. This can sublimate the solid barium complex in the second raw material gas source 32 to thereby create the second raw material gas in the second raw material gas source 32 and the gas supplier 50. Thereafter, opening the valve 53 enables the second raw material gas to be introduced into the reaction vessel 20. When piping dedicated to connect the second gas source 32 to the reaction vessel 20 is disposed, only the piping may be equipped with the heater 52 and the valve 53.

The second raw material gas is required to be gaseous even in a reduced pressure state in which the reaction vessel 20 is filled with the second raw material gas. For this purpose, in the embodiment, a heater 22 is disposed in a supporting table 21 that supports an object 1. The heater 22 can maintain inside the reaction vessel 20 at the sublimation temperature under reduced pressure. Instead of or in addition to the heater 22, a heater for heating the wall body of the reaction vessel 20 may be disposed.

### 2. ALD Process

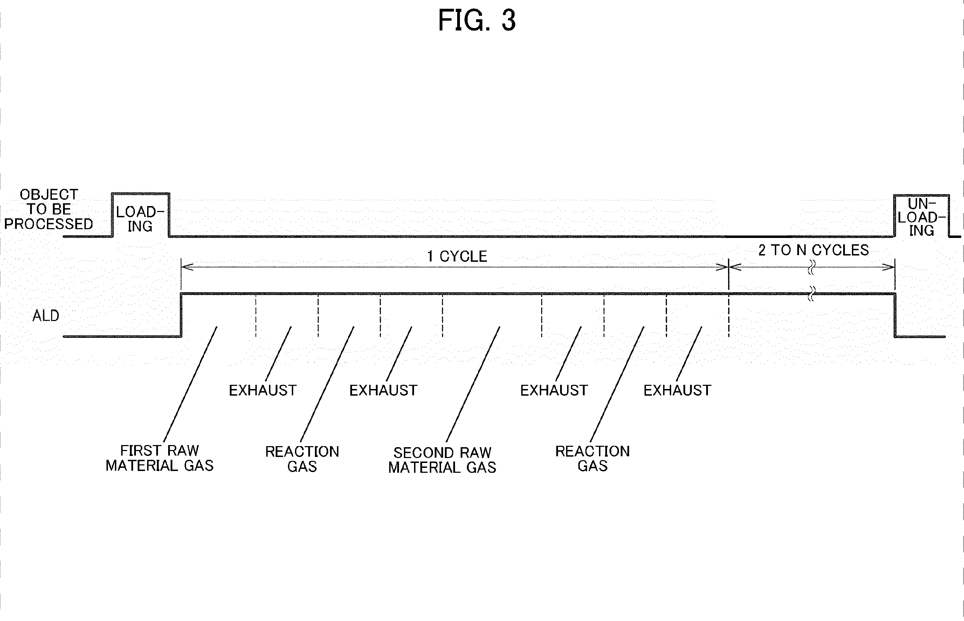

The object 1 is set in the reaction vessel 20, and the ALD cycle is conducted. Generally, the ALD cycle includes at least 4 steps: loading of a raw material gas → exhaust (purge or evacuation) → loading of reaction gas → exhaust, as one cycle. In the embodiment, a film to be formed on the object 1 in the ALD apparatus 10 is a titanium oxide film or a barium oxide film, and these films are alternately formed in a normal order or a reverse order. Accordingly, in the embodiment, the ALD cycle in the embodiment includes loading of the first raw material gas → exhaust → loading of the reaction gas →exhaust → loading of the second raw material gas → exhaust → loading of the reaction gas → exhaust, as one cycle, as illustrated in FIG.3. The thickness of the film to be formed on the object 1 is proportional to the number of the ALD cycles N. Thus, whether the number of cycles counted up at the end of each ALD cycle has reached the set value is judged, and the ALD cycle is repeated for the required number N, as illustrated in FIG. 3.

### 2.1. Titanium Oxide Film

As two precursors, TDMAT (Ti[N(CH₃)₂]₄) from the first raw material gas source 31 and a hydroxyl group OH radical (OH^{∗}) from the reaction gas source 40 are used. On conducting the ALD cycle, first, the inside of the reaction vessel 20 is evacuated by an exhaust pump 61 and set to 10⁻⁴ Pa, for example. Next, as the first step of the ALD cycle, the reaction vessel 20 is filled with the first raw material gas TDMAT (Ti[N(CH₃)₂]₄) at a predetermined pressure, for example, from 1 to 10 Pa. In the first step of the ALD cycle, TDMAT (Ti[N(CH₃)₂]₄) penetrates the surface of the object 1. After a predetermined time period elapses, as the second step of the ALD cycle, and purge gas is introduced into the reaction vessel 20, TDMAT (Ti[N(CH₃)₂]₄) in the reaction vessel 20 is exhausted and replaced by the purge gas.

Next, as the third step of the ALD cycle, the reaction vessel 20 is filled with a hydroxyl group OH radical (OH^{∗}) as the reaction gas at a predetermined pressure, for example, from 1 to 10 Pa. In the third step of the ALD cycle, the OH radical (OH^{∗}) penetrates the surface of the object 1. As a result, TDMAT (Ti[N(CH₃)₂]₄) reacts with the OH radical (OH^{∗}) to create a titanium oxide film TiO₂ on the surface of the object 1. Particularly, organic metal gas can be saturation-adsorbed on the hydroxyl group (hydroxy group (-OH^{∗})) on the surface of the object 1, even at room temperature. Accordingly, it is not necessary to forcibly heat the object 1 during film formation. After a predetermined time period elapses, as the fourth step of the ALD cycle, purge gas is introduced into the reaction vessel 20, and the OH radical (OH^{∗}) in the reaction vessel 20 is replaced by the purge gas. This finishes the film formation step of the titanium oxide film.

### 2.2. Barium Oxide Film

As two precursors, a barium complex from the second raw material gas source 32 and a hydroxyl group OH radical (OH^{∗}) from the reaction gas source 40 are used. First, the inside of the reaction vessel 20 is evacuated by an exhaust pump 61 and set to 10⁻⁴ Pa, for example. Next, as the fifth step of the ALD cycle, the reaction vessel 20 is filled with the second raw material gas (vaporized barium complex) at a predetermined pressure, for example, from 1 to 10 Pa. In the fifth step of the ALD cycle, the vaporized barium complex penetrates the surface of the object 1. After a predetermined time period elapses, as the sixth step of the ALD cycle, purge gas is introduced into the reaction vessel 20, and the vaporized barium complex in the reaction vessel 20 is exhausted and replaced by the purge gas.

Next, as the seventh step of the ALD cycle, the reaction vessel 20 is filled with a hydroxyl group OH radical (OH^{∗}) as the reaction gas at a predetermined pressure, for example, from 1 to 10 Pa. In the seventh step of the ALD cycle, the OH radical (OH^{∗}) penetrates the surface of the object 1. As a result, the vaporized barium complex reacts with the OH radical (OH^{∗}) to create a barium oxide film BaO₂ on the surface of the object 1. Organic metal gas can be saturationadsorbed particularly on the hydroxyl group (hydroxy group (-OH^{∗})) on the surface of the object 1, even at room temperature. It should be noted that the object 1 is forcibly heated with the heater 22 during film formation in order to maintain the vaporized barium complex. After a predetermined time period elapses, as the eighth step of the ALD cycle, purge gas is introduced into the reaction vessel 20, and the OH radical (OH^{∗}) in the reaction vessel 20 is replaced by the purge gas. This finishes the film formation step of the barium oxide film.

### 3. Film Formation of Barium Titanate BaTiO₃

When the titanium oxide TiO₂ film and the barium oxide BaO film are regularly arranged, a barium titanate film BaTiO₃ is formed. The reason is as follows: particularly, the barium oxide BaO film is formed in a heated state at 200°C or more; thus, at the moment of adsorption and oxidization, two types of layers are stacked, turning into a thermodynamically stable system (i.e. BaTiO₃) over time.

### 4. Sublimation of Barium Complex

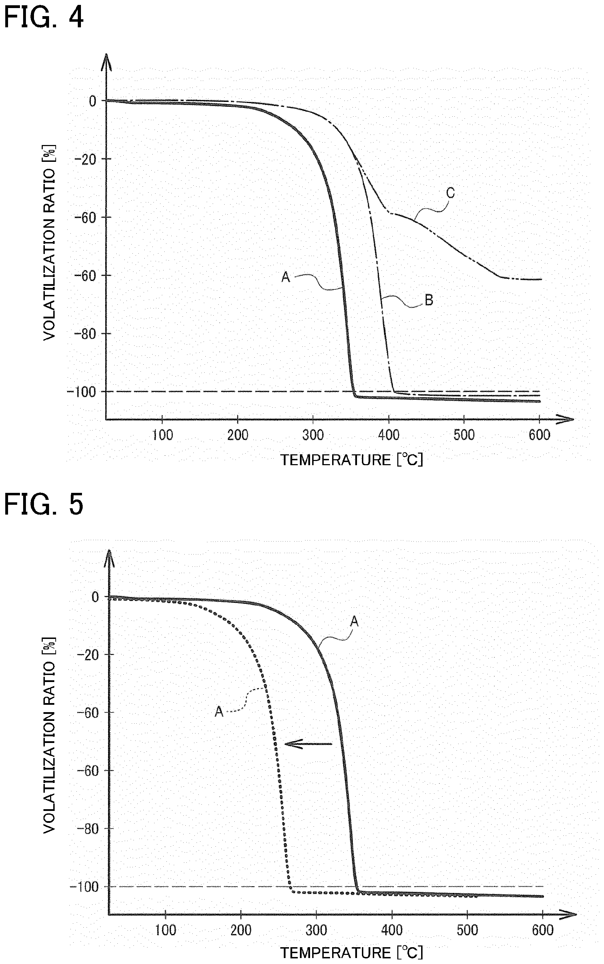

The barium complex is solid at normal temperature and thus required to be heated to the sublimation temperature. FIG. 4 is a characteristic graph illustrating the volatilization ratio (sublimation ratio) of various barium complexes at normal pressure. The barium complex A is represented by the chemical formula 1, the barium complex B is represented by the chemical formula 2, and the barium complex C is represented by the chemical formula 3. The barium complexes A to C are all examples of β-diketone.

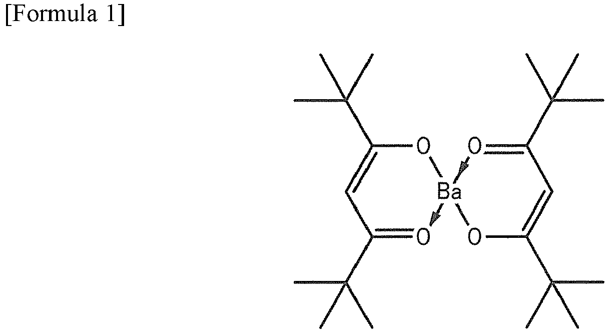

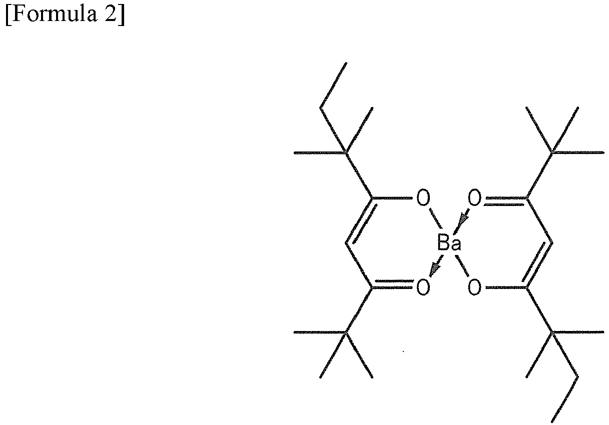

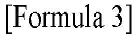

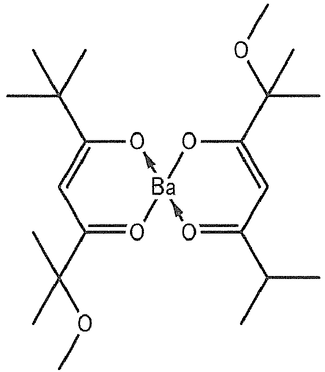

The barium complex A is a white solid having a melting point of 217°C and is known as Ba-0100 (trade name) of ADEKA Corporation. The barium complex B is a white solid having a melting point of 147°C, and the barium complex C is a white solid having a volatilization ratio of 61%.

It can be seen from FIG. 4 that the barium complex A starts to sublimate at the lowest temperature among the three barium complexes A, B, and C. The sublimation temperature becomes lower under reduced pressure than that under normal pressure. FIG. 5 illustrates that the volatilization ratio (sublimation ratio) of the barium complex A shifts from the temperature characteristics under normal pressure represented by the solid line to the temperature characteristics under reduced pressure represented by the dashed line. This applies equally to the other barium complexes. In other words, heating the second raw material gas source 32 and the gas supplier 50 under reduced pressure enables the barium complexes to sublimate at a temperature lower than that under normal pressure. The temperature at which the vaporized barium complex in the depressurized reaction vessel 20 is heated with the heater 22 also can be lowered. The barium complex A can be vaporized when heated to 200°C or more, for example, because the volatilization ratio (sublimation ratio) is not required to be 100%, according to FIG. 5.

Although only some embodiments of the present invention have been described in detail above, those skilled in the art will readily appreciate that many modifications are possible in the embodiments without materially departing from the novel teachings and advantages of this invention. Accordingly, all such modifications are intended to be included within scope of this invention.

## Claims

1. A method for producing a barium titanate film, comprising forming a barium titanate film on a surface of an object by conducting an ALD cycle in a reaction vessel, wherein
the ALD cycle comprises forming a titanium oxide film and forming barium oxide film, the forming of a titanium oxide film comprises:
filling the reaction vessel with TDMAT (Ti[N(CH₃)₂]₄),
exhausting the TDMAT from the reaction vessel,
filling the reaction vessel with an OH radical, and
exhausting the OH radical from the reaction vessel;
the forming of barium oxide film comprises:
filling the reaction vessel with a vaporized barium complex,
exhausting the barium complex from the reaction vessel,
filling the reaction vessel with an OH radical, and
exhausting the OH radical from the reaction vessel; and
the titanium oxide film and the barium oxide film are alternately formed in a normal order or a reverse order.

2. The method for producing a barium titanate film according to claim 1, wherein
the barium complex is sublimated and vaporized by heating under reduced pressure.

3. The method for producing a barium titanate film according to claim 2, wherein
a vessel that contains the barium complex to be charged as solid and piping that connects the vessel with the reaction vessel are each heated and depressurized, and the vaporized barium complex is introduced into the reaction vessel.

4. The method for producing a barium titanate film according to claim 3, wherein
the reaction vessel is evacuated to depressurize the vessel and the piping.

5. The method for producing a barium titanate film according to any one of claims 2 to 4, wherein
the object is heated to form the barium oxide film.

6. The method for producing a barium titanate film according to any one of claims 1 to 5, wherein
the barium complex is β-diketone.

7. The method for producing a barium titanate film according to claim 6, wherein
the barium complex is represented by the following chemical formula 1:

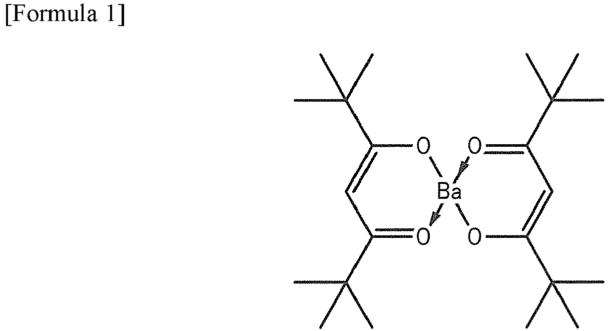

8. The method for producing a barium titanate film according to claim 6, wherein
the barium complex is represented by the following chemical formula 2:

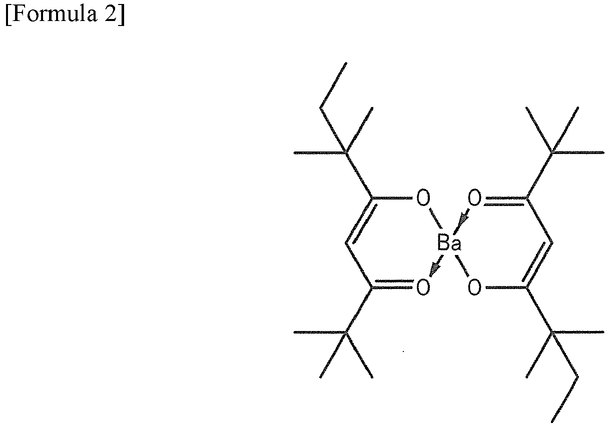

9. The method for producing a barium titanate film according to claim 6, wherein
the barium complex is represented by the following chemical formula 3:
